Europäisches Patentamt

European Patent Office

Office européen des brevets

(11) Publication number: **0 196 912**
**B1**

(12)

# EUROPEAN PATENT SPECIFICATION

(45) Date of publication of the patent specification:
20.06.90

(51) Int. Cl.⁵: **G01R 17/18**

(21) Application number: 86302399.0

(22) Date of filing: 01.04.86

(54) Capacitance bridge.

(30) Priority: 29.03.85 US 717777

(43) Date of publication of application:
08.10.86 Bulletin 86/41

(45) Publication of the grant of the patent:
20.06.90 Bulletin 90/25

(84) Designated Contracting States:
DE FR GB IT NL SE

(56) References cited:
EP-A- 0 141 080
US-A- 3 260 934

(73) Proprietor: HONEYWELL INC., Honeywell Plaza,
Minneapolis Minnesota 55408(US)

(72) Inventor: Kompelien, Arlon D., 6329 Thomas Avenue
South, Richfield Minnesota 55423(US)

(74) Representative: Geissler, Bernhard, Dr. Patent- und
Rechtsanwälte et al, Bardehle-Pagenberg-Dost-
Altenburg-Frohwitter & Partner Postfach 86 06 20,
D-8000 München 86(DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention is concerned with capacitance bridges in which the change of capacitance of a capacitor is measured, and is particularly though not exclusively concerned with enthalpy measuring circuits, which are responsive to both humidity (as measured by a humidity-responsive capacitor) and temperature.

Capacitance monitoring by measuring bridges is well known (see e.g. US-A-4 431 962). However, such circuits are affected by any instability in the power supply and any temperature-responsive variation in the circuit components.

The object of the present invention is to provide an improved capacitance measuring bridge.

This object is achieved by a capacitance measuring bridge as claimed in claim 1.

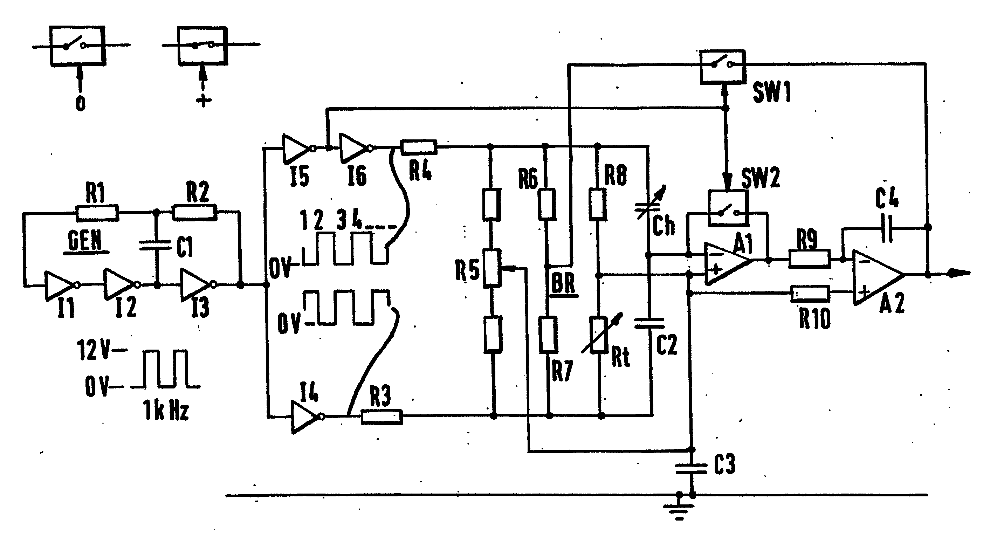

An enthalpy measuring bridge circuit embodying the invention will now be described, by way of example, with reference to the drawing, which is a circuit diagram.

A signal generator GEN comprises three inverters (NOT gates) I1 to I3, two resistors R1 and R2, and a capacitor C1 arranged as shown, to produce a 1:1 ratio square wave of 12 V at 1 kHz. This is fed through an inverter I4, and two inverters I5 and I6, as shown, to provide two complementary square waves as shown. These are fed through resistors R3 and R4 respectively to drive the bottom and top lines respectively of a bridge circuit BR.

The bridge circuit BR has four branches. The first branch is a resistive branch with an adjustable tapped resistor R5 for null balance and calibration. The second branch is a resistive balancing branch with two resistors R6 and R7, used for a feedback signal. The third branch is a resistive temperature sensing branch, with a resistor R8 and a temperature sensitive resistor such as a thermistor Rt. The fourth branch is a capacitive humidity sensing branch, with a capacitor C2 and a humidity sensitive capacitor Ch of polyimide type, for example.

The midpoint of the capacitive branch is connected to the -input of an amplifier A1; the midpoints of the first branch (R5) and the temperature sensing branch are connected together and to a capacitor C3 to earth and to the + input of amplifier A1. The voltage on this capacitor C3 can be regarded as a smoothed reference voltage of approximately half the pulse voltage from generator GEN; the tapping on resistor R5 can be adjusted to provide a null for the desired conditions of the sensing elements Rt and Ch, at the output of amplifier A1.

A second amplifier A2 has its - input fed, via a resistor R9, with the output of amplifier A1 and a feedback capacitor C4, so that it acts as an integrator, with a response which is slow compared to the generator GEN frequency. The + input of amplifier A2 is fed from the reference capacitor C3 via a resistor R10. The output of amplifier A2 is a smoothed DC voltage indicative of enthalpy, as measured by the humidity and temperature sensing elements Ch and Rt.

To improve the operation of the circuit as described so far, there are two conventional solid state switches SW1 and SW2. These are controlled by the pulse voltage from inverter I5 to close when the output of I5 is positive. Switch SW1 provides feedback for the bridge BR by connecting the integrator A2-C4 output to the bridge balancing branch R6-R7. The second switch SW2 connects the output of amplifier A1 back to its - input.

The pulsed supply to the bridge BR results in the bridge being driven with a 12 V alternating square wave, with the voltage across it being positive at the top for say even halfcycles and negative at the top for odd halfcycles. The switches SW1 and SW2 are closed on the odd (negative at top, positive at bottom) cycles.

Suppose that the two capacitors Ch and C2 are of equal value, and the circuit is in a steady state. The reference voltage on capacitor C3 is approximately equal to half the drive voltage, 6 V, and the output of the integrator A2-C4 is also approximately equal to half the drive voltage, 6 V. The approximations are because the inputs to the amplifier A2 must be slightly different, to produce an output of 6 V, so that the output of amplifier A1 must be approximately 6 V, and the two inputs to amplifier A1 must also be slightly different, to produce the requisite output. The balance points in all four branches of the bridge are at approximately 6 V. On the odd half-cycles, the top of the bridge is driven by 12 V and the bottom by 0 V; on the even half-cycles, the top of the bridge is driven by 0 V and the bottom by 12 V.

As a general matter, it must also be noted that on the odd half-cycles, switches SW1 and SW2 are closed, and the conditions in the bridge are determined by the outputs from the two amplifiers A1 and A2; the bridge output (from branches R8-Rt and Ch-C2) has no effect. On the even half-cycles, however, the switches SW1 and SW2 are open, and the conditions in the bridge are determined by the drive from the generator GEN, the reference voltage on capacitor C3, and the voltage which was imposed on the junction of Ch and C2.

Consider now the function of the switch SW2. During an odd half-cycle, this switch is closed. Since the output impedance of amplifier A1 is low, the output of A1 is determined solely by the voltage on C3, and the - input to A1 is driven to approximately equal the voltage on C3 (with a difference which, when amplified by A1, makes the output of A1 equal to its - input and so almost equal to its + input). This voltage is thus placed on the junction between the capacitors Ch and C2. This voltage includes any offset voltage which the amplifier A1 produces. Thus on the next (even) half-cycle, the offset voltage is presented to A1 along with any bridge unbalance, and the bridge unbalance is accurately amplified with compensation for the offset voltage.

The amplifier A1 also, on the odd half-cycles, feeds a voltage to the integrator A2-C4 which is approximately equal to the voltage on the reference capacitor C3. So the change in the integrator output during this odd half-cycle is negligible. That is, the integrator output changes only on the even half-cycles.

In the balanced condition, we thus have the junction of Ch and C2 held at 6 V on the odd half-cycles, with the top of the bridge positive and the bottom negative relative to this 6 V. On the even half-cycles, the square wave drive to the bridge reverses. Since the changes at the top and bottom of the bridge are equal and opposite, and capacitors Ch and C2 are equal, the voltage at their junction will thus not change.

Suppose now that the capacitance of Ch increases. The Ch-C2 junction will still be forced to 6 V (i.e. approx the voltage on C3) on the odd half-cycles. But on the even half-cycles, the voltage at this point will rise. The charge flowing through the Ch-C2 branch of the bridge on the reversal of the drive voltage produces a larger change in the voltage across the smaller capacitor, C2, than across the larger capacitor, Ch, because C2 is smaller than Ch. Thus the voltage at the Ch-C2 junction tends to follow the top of the bridge.

This rise at the Ch-C2 junction produces a fall at the output of A1 and a rise at the output of the integrator A2-C4. Over the long term, this will produce a steadily rising output. However, the feedback switch SW1 limits this rise. On the odd half-cycles, the increasing voltage from the integrator is fed back to the bridge BR, via the branch R6-R7, and tends to pull the voltages in the bridge up. Since, on the odd half-cycles, the junction of Ch and C2 is forced to approximately the reference voltage of 6 V, this means that the voltage across Ch on the odd half-cycles will decrease from 6 V (because the top of the bridge is pulled up from the balanced level) and the voltage across C2 will increase from 6 V (because the voltage on the bottom of the bridge will also be pulled up). It will be realized that although the bridge has been discussed as if it were driven by a 12 V square wave, the actual voltages on the top and bottom of the bridge will be somewhat above 0 V and somewhat below 12 V because the true 0 V and 12 V values from inverters I4 and I6 are diminished by the voltage divider effect of the resistor chains R4-R6 and R3-R7 to the output of A2.

The result of this is that when the change from an odd half-cycle to an even half-cycle occurs, the rising voltage change at the top of the bridge will be less than for the balanced condition, and the falling voltage change at the bottom of the bridge will be greater. The change in the voltage at the Ch-C2 junction will therefore be reduced. In consequence, the input to the integrator A2-C4 will be reduced, and the integrator output will rise less rapidly. There is thus a negative feedback around the system from the bridge, through the amplifier A1 and the integrator A2, and back through switch SW1 to the bridge, and this negative feedback operates to re-establish an equilibrium condition after the bridge becomes unbalanced by a change in humidity and the capacitance of sensor Ch.

A change in temperature will change the resistance of Rt, and hence the reference voltage on capacitor C3. This will unbalance the circuit, and a rebalancing to equilibrium conditions will occur in the same manner as if the humidity had changed. Thus the circuit output represents enthalpy, a combination of temperature and humidity.

## Claims

1. A capacitance sensing circuit comprising:
a bridge (BR) with two branches connected in parallel each consisting of two series connected legs, the mid-connection points of the legs being connected respectively to the first and to the second input of a differential amplifier (A1),
with a variable capacitor (Ch) and a reference capacitor (C2) in the first, capacitive branch, and with a second, resistive branch (R8, Rt),
a balanced square wave drive means (GEN) for the bridge, characterized by:
an integrator (A2, C4) fed from the amplifier;
a first feedback switch (SW2) connecting the output of the amplifier to the midpoint of the capacitive branch;
a second feedback switch (SW1) connecting the output of the integrator to the midpoint of a third, resistive branch (R6, R7),
both switches being controlled by the same half wave of the square wave drive means and all branches being connected in parallel between the drive means.

2. A circuit according to claim 1, characterized in that the variable capacitor (Ch) is responsive to humidity and a variable resistor (Rt) in the second, resistive branch is sensitive to temperature, whereby the circuit measures enthalpy.

3. A circuit according to claim 2, characterized in that the variable capacitor (Ch) is connected to a terminal of the drive means (GEN) supplying a square wave voltage of one polarity, and the variable resistor (Rt) is connected to a terminal of the drive means supplying a square wave voltage of the opposite polarity.

4. A circuit according to either previous claim, characterized by a fourth, resistive branch with an adjustable midpoint (R5) being connected to the non-inverting input of the amplifier (A1) and to one electrode of a capacitor (C3), the midpoint of the second, resistive branch (R6, R7) being also connected to said non-inverting input, the midpoint of the capacitive branch being connected to the inverting input of the amplifier, and the other electrode of the capacitor being connected to a reference potential (ground).

## Patentansprüche

1. Kapazitätsfühlerschaltung, die aufweist:
eine Brücke (BR) mit zwei Zweigen, die parallel zueinander verbunden sind, wobei jeder aus zwei in Serie verbundenen Nebenzweigen besteht und die Mittenverbindungspunkte der Nebenzweige sind jeweils mit dem ersten bzw. zweiten Eingang eines Differenzverstärkers (A1) verbunden,
mit einem variablen Kondensator (Ch) und einem Referenzkondensator (C2) in dem ersten, kapazitiven Zweig und mit einem zweiten Widerstandszweig (R8, Rt),

eine Treibereinrichtung (GEN) für symmetrische Rechteckwellen für die Brücke,
gekennzeichnet durch:
einen Integrator (A2, C4), der von dem Verstärker versorgt wird;
einen ersten Rückkoppelschalter (SW2), der den Ausgang des Verstärkers mit dem Mittenpunkt des kapazitiven Zweiges verbindet;
einen zweiten Rückkoppelschalter (SW1), der den Ausgang des Integrators mit dem Mittenpunkt eines dritten Widerstandszweiges (R6, R7) verbindet,
wobei beide Schalter mit der gleichen Halbwelle der Treibereinrichtung für Rechteckwellen gesteuert werden und alle Zweige parallel zur Treibereinrichtung verbunden sind.

2. Schaltung nach Anspruch 1, dadurch gekennzeichnet, daß der variable Kondensator (Ch) auf Feuchtigkeit reagiert und ein variabler Widerstand (Rt) in dem zweiten Widerstandszweig empfindlich auf Temperatur ist, wobei die Schaltung die Enthalpie mißt.

3. Schaltung nach Anspruch 2, dadurch gekennzeichnet, daß der variable Kondensator (Ch) mit einem Anschluß der Treibereinrichtung (GEN) verbunden ist, der eine Rechteckwellenspannung einer Polarität zuführt, und daß der variable Widerstand (Rt) mit einem Anschluß der Treibereinrichtung verbunden ist, der eine Rechteckwellenspannung entgegengesetzter Polarität zuführt.

4. Schaltung nach einem der vorhergehenden Ansprüche, gekennzeichnet durch einen vierten Widerstandszweig mit einem einstellbaren Mittenpunkt (R5), der mit dem nichtinvertierenden Eingang des Verstärkers (A1) und mit einer Elektrode eines Kondensators (C3) verbunden ist, wobei der Mittenpunkt des zweiten Widerstandszweiges (R6, R7) ebenfalls mit dem nichtinvertierenden Eingang verbunden ist, und der Mittenpunkt des kapazitiven Zweiges mit dem invertierenden Eingang des Verstärkers verbunden ist und die andere Elektrode des Kondensators mit einem Referenzpotential (Masse) verbunden ist.

**Revendications**

1. Circuit de détection capacitif comprenant:
- un pont (BR) ayant deux branches reliées en parallèle et comprenant chacune deux pattes reliées en série, les points de connexion médians desdites pattes étant reliés respectivement à la première et à la seconde entrée d'un amplificateur différentiel (A1),
- une capacité variable (Ch) et une capacité de référence (C2) dans la première branche capacitive, et une seconde branche résistive (R8, Rt),
- des moyens de commande équilibrés à onde rectangulaire (GEN) pour le pont,
caractérisé par:
- un intégrateur (A2, C4) alimenté à partir de l'amplificateur,
- un premier commutateur de contre-réaction (SW2) reliant la sortie de l'amplificateur au point médian de la branche capacitive,
- un second commutateur de contre-réaction (SW1) reliant la sortie de l'intégrateur au point médian d'une troisième branche résistive (R6, R7), les deux commutateurs étant commandés par la même demi-onde des moyens de commande à onde rectangulaire et toutes les branches étant reliées en parallèle entre les moyens de commande.

2. Circuit selon la revendication 1, caractérisé en ce que la capacité variable (Ch) est sensible à l'humidité et en ce qu'une résistance variable (Rt) placée dans la seconde branche résistive est sensible à la température, de sorte que le circuit mesure des enthalpies.

3. Circuit selon la revendication 2, caractérisé en ce que la capacité variable (Ch) est reliée à une borne des moyens de commande (GEN) fournissant une tension à onde rectangulaire d'une polarité, et en ce que la résistance variable (Rt) est reliée à une borne des moyens de commande délivrant une tension à onde rectangulaire de polarité opposée.

4. Circuit selon l'une des revendications précédentes, caractérisé par une quatrième branche résistive comprenant un point médian réglable (R5) qui est relié à l'entrée non inversée de l'amplificateur médian et à une électrode d'une capacité (C3), le point médian de la seconde branche résistive (R6, R7) étant également relié à ladite entrée non reversible, le point médian de la branche capacitive étant relié à l'entrée reversible de l'amplificateur, et l'autre électrode de la capacité étant reliée à un potentiel de référence (terre).